# EUROPÄISCHE PATENTSCHRIFT

(11) **EP 1 579 749 B1**
(45) Veröffentlichungstag und Bekanntmachung des Hinweises auf die Patenterteilung: **12.03.2008**
(21) Anmeldenummer: 03767448.8
(22) Anmeldetag: 25.11.2003
(51) Int. Cl.: H05K 9/00

(54) **Abschirmgehäuse zur Aufnahme einer elektronischen Schaltung**
Shielding housing for an electronic circuit
Boîtier de blindage servant a loger un circuit électronique

(30) Priorität: 09.12.2002 DE 10257615
(43) Veröffentlichungstag der Anmeldung: 28.09.2005
(73) Patentinhaber: Audioton Kabelwerk GmbH Zweigniederlassung Scheinfeld, 91443 Scheinfeld (DE)
(72) Erfinder: LEINFELDER, Klaus, 90522 Oberasbach (DE)
(74) Vertreter: Lelgemann, Karl-Heinz
(86) Internationale Anmeldenummer: PCT/DE2003/003902
(87) Internationale Veröffentlichungsnummer: WO 2004/054343

(56) Entgegenhaltungen:
- EP-A- 0 420 504
- DD-A- 216 368
- DE-U- 20 121 740
- US-A- 5 782 370
- PATENT ABSTRACTS OF JAPAN Bd. 1996, Nr. 11, 29. November 1996 (1996-11-29) -& JP 08 186389 A (IKEGAMI TSUSHINKI CO LTD), 16. Juli 1996 (1996-07-16)
- PATENT ABSTRACTS OF JAPAN Bd. 015, Nr. 040 (E-1028), 30. Januar 1991 (1991-01-30) -& JP 02 276295 A (CANON INC), 13. November 1990 (1990-11-13)

## Beschreibung

Die Erfindung betrifft ein Abschirmgehäuse zur Aufnahme einer elektronischen Schaltung bestehend aus mindestens zwei elektrisch leitfähigen Gehäuseteilen, die zumindest bereichsweise formschlüssig ineinander greifen.

Für bestimmte Anwendungen, beispielsweise im Automobilbereich, ist es notwendig, elektrische Schaltungen, Bauelemente und Geräte, die elektromagnetische Strahlung emittieren, abzuschirmen, um eine Funktionsbeeinträchtigung benachbarter Geräte zu vermeiden. Hierzu wird eine elektronische Schaltung in einem abschirmenden Gehäuse untergebracht, das aus einem leitfähigen Material besteht und im Sinne eines faradayschen Käfigs wirkt. Weiter kann es in bestimmten Umgebungen notwendig sein, elektronische Schaltungen gegenüber den am Betriebsort vorhandenen elektromagnetischen Feldern abzuschirmen, um einen störungsfreien Betrieb von elektronischen Schaltungen sicher zu stellen.

Aus EP 0 629 114 A1 ist ein Verfahren zur Herstellung eines Gehäuses mit elektromagnetischer Abschirmung bekannt.

Bei diesem Verfahren wird ein elastisches sowie leitfähiges Material mittels Druck aus einer Nadel oder Düse auf einen Abschnitt eines Gehäuseteils aufgetragen und erbringt im folgenden die Funktion eines Abschirmprofils. Dieses Abschirmprofil stellt die Abschirmung im Bereich von Gehäuse-Trennfugen sicher. Die Nadel oder Düse wird maschinell, insbesondere rechnergesteuert, über den abzuschirmenden Abschnitt des Gehäuseteils geführt, wodurch eine hohe Präzision und große Flexibilität bei der Formgebung des Profils gewährleistet wird.

Andererseits erfordert ein derartiges Aufbringen einer elektromagnetisch abschirmend wirkenden Dichtmasse einen zusätzlichen Verfahrensschritt und komplizierte, rechnergesteuerte Apparaturen.

Weiter wird in DE 3 815 517 A1 ein Abschirmgehäuse beschrieben, das wie folgt beschrieben aufgebaut ist:

Um eine einwandfreie HF-Abschirmung von tragbaren Funkgeräten zu erreichen, muß für eine elektrisch leitende Verbindung zwischen einem Gehäuseunterteil und einem Gehäuseoberteil gesorgt werden. Dies wird durch metallisierte Dichtungen erreicht. Diese Dichtungen müssen am metallisch blanken Gehäuseinneren anliegen, da sonst die Abschirmwirkung stark beeinträchtigt wird. Um eine Korrosion der Gehäuseteile zu verhindern, wird vorgeschlagen, die Dichtungen aus einem nicht leitenden Teil aus einem gummielastischen Werkstoff aufzubauen, der an oberflächengeschützten außen liegenden Gehäuseteilen anliegt, und aus einem leitenden Teil aufzubauen, der an metallisch blanken, innen liegenden Gehäuseteilen anliegt. In den aneinander zugewandten Stirnflächen der Ränder des Gehäuseoberteils und des Gehäuseunterteils sind Nuten eingebracht, in denen die Dichtung geführt wird. Eine galvanische Verbindung zwischen Gehäuseoberteil und Gehäuseunterteil wird durch die Verpressung der elastischen Dichtung zwischen Gehäuseoberteil und Gehäuseunterteil erreicht.

Das Dokument DD 216 368 A1 beschreibt ein hochfrequenzdichtes, lösbar verschlossenes, aus einem umlaufenden geschlossenen Rahmen und aus mindestens einem Deckel bestehendes metallisiertes Plastgehäuse. Der Rahmen und der Deckel besteht aus einem metallisierten Plastwerkstoff relativ geringer elastischer Dehnbarkeit. Beim Zusammenfügen des Deckels mit dem Rahmen greift ein an dem Deckel vorgesehener, elastisch verformbarer, umlaufender geschlossener Kragen In eine geneigte Innenfläche des Rahmens nach Art einer Übermaßpassung (unterschiedliche Neigungswinkel) ein, so daß eine allseitige hochfrequenzdichte, lösbare Verbindung entsteht.

Der Erfindung liegt die Aufgabe zugrunde, den Aufbau eines funktionellen und kostengünstig herstellbaren Abschirmgehäuses zur Aufnahme einer elektronischen Schaltung anzugeben.

Diese Aufgabe wird gelöst durch ein Abschirmgehäuse zur Aufnahme einer elektronischen Schaltung, das aus mindestens zwei elektrisch leitfähigen Gehäuseteilen besteht, die zumindest bereichsweise formschlüssig ineinander greifen, bei dem formschlüssig ineinander greifende erste und zweite Randbereiche eines ersten Gehäuseteils bzw. eines zweiten Gehäuseteils einander zugewandte erste Flächen bzw. zweite Flächen aufweisen, wobei die ersten Flächen an der Außenseite des ersten Gehäuseteils und die zweiten Flächen an der Innenseite des zweiten Gehäuseteils angeordnet sind und die ersten und zweiten Flächen als Übermaßpassung zusammenwirken und beim Zusammenfügen des ersten Gehäuseteils und des zweiten Gehäuseteils gegeneinander gepreßt werden, bei dem mindestens ein Bereich des ersten Randbereichs mit einer der ersten Flächen und/oder ein Bereich des zweiten Randbereichs mit einer der zweiten Flächen durch Nuten segmentiert ist, bei dem der zweite Randbereich mindestens eine Rippe aufweist, die auf eine an der Innenseite des ersten Gehäuseteils angeordnete dritte Fläche des ersten Randbereiches zum Erzeugen einer Keilkraft eingreift, und bei dem die ersten und die zweiten Flächen und/oder die mindestens eine Rippe und die dritte Fläche eine zumindest bereichsweise elektrisch leitfähige Oberfläche aufweisen, so daß eine galvanische Verbindung der ineinander greifenden ersten und zweiten Gehäuseteile durch das Zusammenfügen des ersten und des zweiten Gehäuseteils bewirkt wird.

Durch die erfindungsgemäße Ausgestaltung eines Abschirmgehäuses wird eine Vielzahl von Vorteilen erreicht:

Es wird eine sicherere Abschirmung der sich in dem Gehäuse befindlichen elektronischen Schaltung erreicht, ohne elektromagnetische Strahlung abschirmende Dichtungsmassen oder Dichtungsringe verwenden zu müssen. Hierdurch vereinfacht sich die Montage und Fertigung eines Abschirmgehäuses.

Weiter wird eine sichere Kontaktierung zwischen Gehäuseteilen auch unter schwierigen Umweltbedingungen erreicht: Durch die spezielle Ausgestaltung der ersten und zweiten Randbereiche (Übermaß, Segmentierung) wird ein konstanter Anpreßdruck zwischen den ersten und zweiten Flächen bewirkt. Die mittels der Rippen erzeugte zusätzliche Keilkraft stellt sicher, daß dieser konstante Anpreßdruck auch bei hohen Temperaturschwankungen aufrecht erhalten wird, die ansonsten durch Materialverformung eine Verringerung des Anpreßdruckes erzeugen könnten. Durch das Zusammenwirken dieser Elemente wird eine EMV-Abschirmung (EMV = elektromagnetische Verträglichkeit) bereit gestellt, die im hohen Maße klimafest und alterungsbeständig ist. Aufgrund dieser Eigenschaften eignet sich ein erfindungsgemäßes Abschirmgehäuse besonders für den Einsatz im Automobilbereich.

Vorteilhafte Ausgestaltungen der Erfindung sind den Unteransprüchen zu entnehmen.

Als zweckmäßig hat es sich erwiesen, als Material für das erste und das zweite Gehäuseteil einen leitfähigen Kunststoff zu verwenden. Weiter ist es zweckmäßig als erste und zweite Gehäuseteile Kunststoffformteile zu verwenden, die mit einer leitfähigen Schicht versehen sind.

Als besonders vorteilhaft hat es sich bei der praktischen Anwendung erwiesen, daß die ersten Flächen gegenüber den zweiten Flächen ein Übermaß von 0,1 mm bis 0,2 mm aufweisen. Die Herstellung und Montage eines erfindungsgemäßen Abschirmgehäuses vereinfacht sich weiter dadurch, daß dieses Übermaß durch eine Neigungswinkeldifferenz zwischen den ersten Flächen und den zweiten Flächen bewirkt wird.

Gemäß einem bevorzugten Ausführungsbeispiel der Erfindung ist der erste Randbereich segmentiert und der zweite Randbereich nicht segmentiert. Hierdurch ist es möglich, die Kontaktierung zwischen erstem und zweitem Gehäuseteil vor schädlichen Umwelteinflüssen (Korrosion usw.) zu schützen und damit die Langlebigkeit der Abschirmwirkung eines erfindungsgemäßen Abschirmgehäuses sicher zu stellen.

Die Klima-Stabilität der Abschirmwirkung eines erfindungsgemäßen Abschirmgehäuses wird durch folgende Maßnahmen weiter verbessert:

Durch Nuten begrenzte Bereiche des ersten Randbereiches definieren Segmente des ersten Randbereiches. Der zweite Randbereich weist mindestens eine Rippe pro Segment des ersten Randbereichs auf, wobei die Rippen zum Eingriff auf die jeweiligen zugeordneten Segmente des ersten Randbereiches angeordnet sind. Es wird demnach jedes einzelne Segment des ersten Randbereiches durch die Einwirkung der zugeordneten Rippe vor klimabedingten Verformungen geschützt.

Weiter kann der zweite Randbereich zwei Rippen aufweisen, die zum Eingriff in ein Segment des ersten Randbereiches angeordnet sind, so daß die Rippen jeweils benachbart zu den das Segment begrenzenden Nuten in das Segment des ersten Randbereiches eingreifen. Dies stellt einen besonders umfassenden Verformungsschutz des jeweiligen Segments dar.

Weitere Vorteile werden dadurch erzielt, daß die Nuten zur Segmentierung der ersten Fläche in einem Abstand kleiner als 25 mm angeordnet sind oder daß die mindestens eine Rippe konisch ausgeformt ist.

Kosteneinsparungen können dadurch erzielt werden, daß die Rippen nur in Bereichen des Gehäuses vorgesehen sind, in denen eine EMV-Abschirmung vorzusehen ist.

Um die Abschirmwirkung des erfindungsgemäßen Abschirmgehäuses zu verbessern, ist das Abschirmgehäuse elektrisch mit einem Massekontakt der sich in dem Gehäuse befindlichen elektronischen Schaltung zu verbinden. Eine besonders kostengünstige und sichere Möglichkeit einer solchen Kontaktierung wird dadurch erreicht, daß das Abschirmgehäuse, das zur Aufnahme mindestens einer Platine ausgeformt ist, ein oder mehrere Stege zum Eingriff auf eine entsprechend angeordnete Kontaktfläche der Platine aufweist, daß die der Platine zugewandte Stirnfläche der einen oder mehreren ersten Stege eine zumindest partiell leitfähige Oberfläche aufweist und ein oder mehrere Zähne besitzt und daß die ein oder mehreren ersten Stege gegenüber der in dem Gehäuse anzuordnenden Platine ein Übermaß besitzen, so daß beim Zusammenfügen der Gehäuseteile die Stirnflächen der ein oder mehreren ersten Stege derart gegen die zugeordneten Kontaktflächen der Platine gepreßt werden, daß eine Verformung der Zähne und eine galvanische Verbindung zwischen dem Gehäuseteil und den Kontaktflächen der Platine bewirkt werden.

Vorteilhaft ist es hierbei, wenn sowohl das erste Gehäuseteil als auch das zweite Gehäuseteil derartige Stege besitzt. Wenn diese Stege symmetrisch zueinander angeordnet sind, wird ein Verformen der Platine durch den entstehenden Anpreßdruck vermieden und eine gleichmäßige und sichere elektrische Kontaktierung zwischen den Kontaktflächen der Platine und den Stegen erreicht.

Die Zähne sind zweckmäßigerweise dreieckförmig auszuformen, wobei die Zähne vorzugsweise eine einen 90°-Winkel bildende Spitze aufweisen.

Als vorteilhaft in der praktischen Anwendung hat es sich erwiesen, daß die Stege gegenüber der Platine ein Übermaß von etwa 0,2 mm besitzen.

Weiter ist es auch möglich, daß durch die Stege zusätzlich eine mechanische Stabilisierung der Platine innerhalb des Abschirmgehäuses bewirkt wird. Hierzu ist es vorteilhaft, daß das Abschirmgehäuse zwei erste Stege und zwei zweite Stege aufweist, die an gegenüberliegenden Enden der Platine in zugeordnete Kontaktflächen eingreifen.

Im folgenden wird die Erfindung anhand von mehreren Ausführungsbeispielen unter Zuhilfenahme der beiliegenden Zeichnungen beispielhaft erläutert.
- Fig. 1: zeigt eine räumliche Darstellung eines Gehäuseteils eines erfindungsgemäßen Abschirmgehäuses.
- Fig. 2: zeigt eine räumliche Darstellung eines Gehäuseteils für ein erfindungsgemäßes Abschirmgehäuse, das von dem Gehäuseteil nach Fig. 1 und dem Gehäuseteil nach Fig. 2 gebildet wird.
- Fig. 3: zeigt einen Schnitt durch das Gehäuseteil nach Fig. 1.
- Fig. 4: zeigt einen Schnitt durch das Gehäuseteil nach Fig. 2.
- Fig. 5: zeigt eine Schnittdarstellung eines erfindungsgemäßen Abschirmgehäuses, das von den Gehäuseteilen nach Fig. 1 und Fig. 3 gebildet wird und eine elektronische Schaltung aufweist.
- Fig. 6: zeigt eine Schnittdarstellung eines Randbereiches des Gehäuseteils nach Fig. 2.
- Fig. 6b: zeigt eine Schnittdarstellung eines Randbereiches des Gehäuseteils nach Fig. 1.
- Fig. 6c: zeigt eine Schnittdarstellung, die das Ineinandergreifen der Randbereiche der Gehäuseteile nach Fig. 1 und Fig. 2 verdeutlicht.
- Fig. 7a: zeigt eine Konstruktionsskizze, die die Gestaltung eines Steges für ein erfindungsgemäßes Abschirmgehäuse verdeutlicht.
- Fig. 7b: zeugt eine Schnittdarstellung eines erfindungsgemäßen Abschirmgehäuses, das von den Gehäuseteilen nach Fig. 1 und Fig. 2 gebildet wird.
- Fig. 7c: zeigt eine Detailansicht eines Ausschnitts aus der Darstellung nach Fig. 7b.

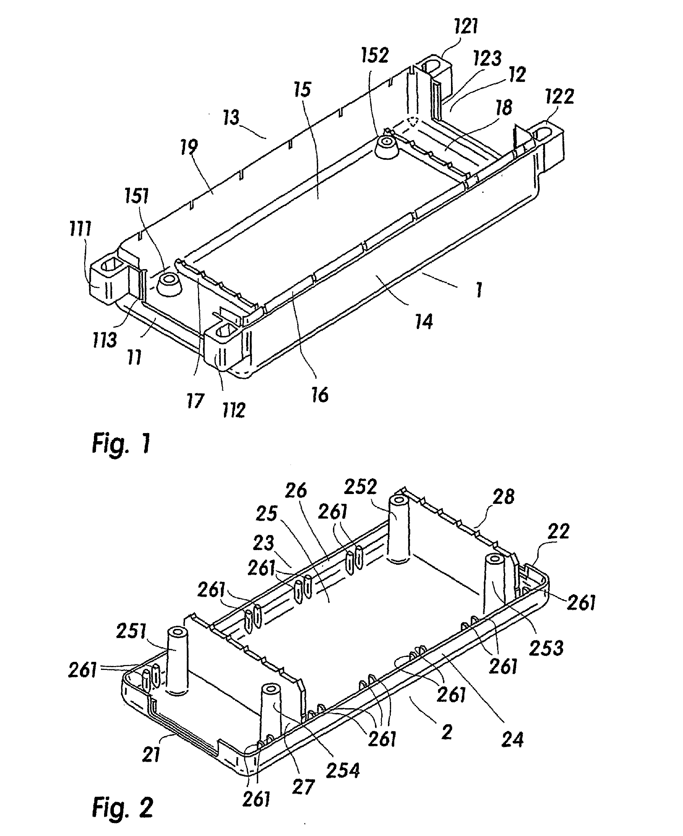

Die Figuren Fig. 1 und Fig. 2 zeigen zwei Gehäuseteile 1 und 2 eines Abschirmgehäuses zur Aufnahme einer elektronischen Schaltung.

Es ist natürlich möglich, daß ein solches Abschirmgehäuse aus mehr als zwei Gehäuseteilen besteht, beispielsweise aus vier Gehäuseteilen besteht, deren Randbereiche wie die Randbereiche der Gehäuseteile 1 und 2 nach Fig. 1 bzw. Fig. 2 formschlüssig ineinander greifen.

Die Gehäuseteile 1 und 2 bestehen jeweils aus einem Kunststoffformteil, das wie in den Figuren Fig. 1 und Fig. 2 gezeigt geformt ist. Dieses Kunststoffformteil ist auf der Innenseite mit einer elektrisch leitfähigen Schicht versehen. Beispielsweise kann diese elektrisch leitfähige Schicht aus einer dünnen Metallschicht bestehen, die durch Aufdampfen auf das Kunststoffformteil gebildet wird. Als Metall für diesen Aufdampfprozeß eignet sich beispielsweise Kupfer oder Aluminium. Weiter ist es auch möglich, eine derartige leitfähige Schicht durch Aufsprühen oder Auftragen von leitfähigen Partikeln zu erzeugen. Weiter ist es möglich, daß die leitfähige Schicht nicht nur auf der Innenseite, sondern auch auf der Außenseite der Gehäuseteile 1 und 2 aufgetragen wird. Weiter ist auch eine partielle Auftragung dieser leitfähigen Schicht möglich.

Das Gehäuseteil 1 besteht aus einem Boden 15 und vier Seitenteilen 11, 12, 13 und 14. Auf dem Boden 15 sind vier Abstandszapfen angeordnet, die jeweils mit einer mittigen Bohrung versehen sind. Von diesen Abstandszapfen sind in Fig. 1 zwei Abstandszapfen 151 und 152 gezeigt. Die Abstandszapfen sind in den Ecken des Gehäuseteils 1 angeordnet und dienen der Verschraubung des Gehäuseteils 1 mit dem Gehäuseteil 2. Weiter zeigt Fig. 1 zwei Stege 17 und 18, die das Gehäuseteil 1 in Querrichtung teilen.

Die Seitenteile 11 und 12 weisen jeweils Befestigungsösen 111 und 112 bzw. 121 und 122 auf. Weiter weisen die Seitenteile 11 und 12 Öffnungen 113 und 123 auf, die der Durchführung von Steckern dienen. Diese Stecker stellen die elektrische Verbindungen zwischen der innerhalb des Abschirmgehäuses anzuordnenden Elektronik und der "Außenwelt" bereit.

Das in Fig. 1 dargestellte Gehäuseteil hat beispielsweise eine Länge von 13,5 cm, eine Breite von 5,5 cm und eine Höhe von 22 mm. Die in Fig. 1 gezeigten Stege 17 und 18 haben beispielsweise eine Dicke von 1 mm und eine Höhe von 3 mm.

Die Randbereiche des Gehäuseteils 1 weisen erste Flächen 16 auf, die durch Nuten segmentiert sind und einzelne Segmente bilden. Die Flächen 16 besitzen beispielsweise eine Höhe von 3 mm, die Segmente besitzen eine Länge von 21 mm und die Nuten besitzen eine Breite von 1 mm. Weiter weist der Randbereich des Gehäuseteils 1 neben den außenliegenden Flächen 16 auch innenliegende dritte Flächen 19 auf.

Das Gehäuseteil 2 besteht aus einem Bodenteil 25 und vier Seitenteilen 21, 22, 23 und 24. An dem Bodenteil 25 sind vier Abstandszapfen 251, 252, 253 und 254 befestigt, die in den Ecken des Gehäuseteils 2 symmetrisch zu den Abstandszapfen des Gehäuseteils 1 angeordnet sind und jeweils über mittige Bohrung verfügen. Weiter weist das Gehäuseteil 2 zwei Stege 27 und 28 auf, die symmetrisch zu den Stegen 17 bzw. 18 innerhalb des Gehäuseteils 2 angeordnet sind.

Das Gehäuseteil 2 hat beispielsweise eine Länge von 13,5 cm, eine Breite von 5,5 cm und eine Höhe von 11 mm. Die Stege 27 und 28 haben beispielsweise eine Dicke von 1 mm und eine Höhe von 23 mm.

Die Randbereiche des Gehäuseteils 2 weisen mehrere Rippen 261 auf. Weiter weist der Randbereich des Gehäuseteils 2 innenliegende Flächenbereiche 26 auf.

Bei der Montage des Abschirmgehäuses werden die beiden Gehäuseteile 1 und 2 zusammengesteckt und mittels in den Bohrungen der Abstandszapfen 251 bis 254 und 151 und 152 geführten Schrauben verschraubt. Die Länge der Abstandszapfen 251 bis 254 und 151 und 152 ist hierbei so gewählt, daß die Höhen der Stege 27, 28, 17 und 18 ein Übermaß gegenüber den jeweiligen Abstandszapfen 251 und 254, 252 und 253, 151 bzw. 152 aufweisen.

Bei der Verschraubung der Gehäuseteile 1 und 2 greifen die Randbereiche der Gehäuseteil 1 und 2 formschlüssig ineinander und stellen neben einer mechanischen Verbindung der Gehäuseteile 1 und 2 auch eine elektrische Verbindung zwischen diesen Gehäuseteilen her.

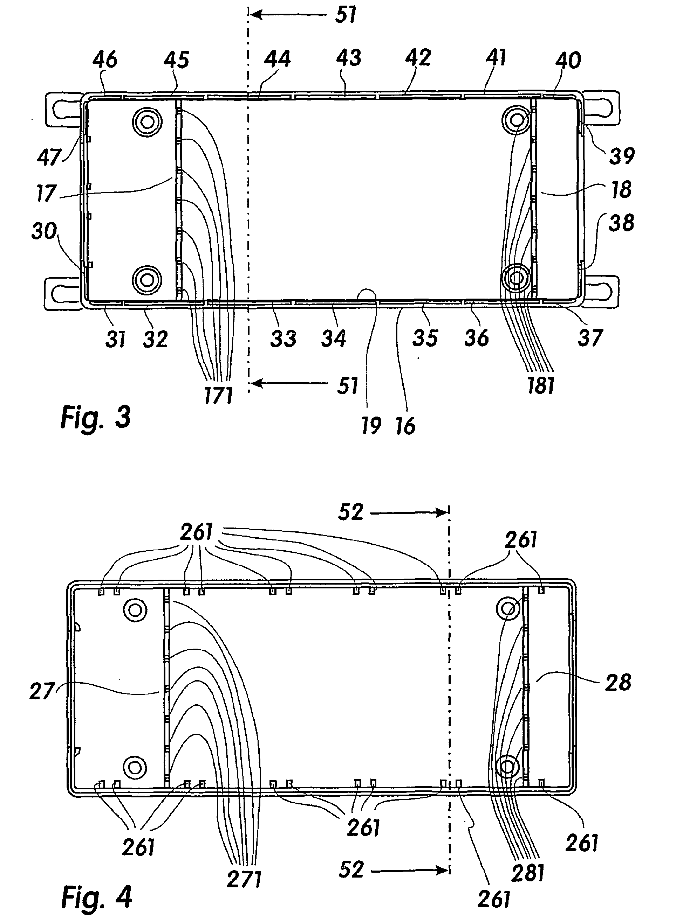

Im folgenden wird anhand der Figuren 3, 4, 6a, 6b und 6c die genaue Funktionsweise der durch das Zusammenfügen der Gehäuseteile 1 und 2 entstehenden mechanischen und elektrischen Verbindungen erläutert.

Die. Figuren 3 und 4 zeigen Längsschnitte der Gehäuseteile 1 und 2. Fig. 3 zeigt das Gehäuseteil 1, dessen Randbereich mehrere Segmente 30 bis 47 aufweist. Die Außenflächen der Segmente 30 bis 47 bilden erste Flächen 16. Die Innenflächen der Segmente 30 bis 47 bilden dritte Flächen 19. Die Länge der einzelnen Segmente 30 bis 47 ist, wie in Fig. 3 gezeigt, unterschiedlich. Die Segmente 30 bis 47 sind jeweils durch Nuten getrennt. Hierbei ist jeweils eine Nut in jeder der Ecken des Gehäuseteils 1 angeordnet.

Es ist hier jedoch auch möglich, daß die Länge der Segmente 30 bis 47 anders als in Fig. 3 dargestellt gewählt ist. Als vorteilhaft hat es sich hierbei erwiesen, die Länge der Segmente 30 bis 47 kleiner als 25 mm zu wählen, um eine ausreichende langlebige Kontaktierung zwischen den Gehäuseteilen 1 und 2 sicher zu stellen. Weiter kann die Breite der die Segmente 30 bis 47 begrenzenden Nuten verändert werden, wobei die Breite der Nuten zumindest eine der Wellenlänge der abzuschirmenden elektromagnetischen Strahlung entsprechende Abmessung nicht überschreiten darf, um eine sichere Abschirmung zu gewährleisten.

Fig. 3 zeigt weiter die Stege 17 und 18, die jeweils mit Zähnen 171 bis 181 versehen sind. Die Anordnung, Breite und Länge der Stege 17 und 18 ist in Fig. 3 beispielhaft dargestellt. Eine Anordnung der Stege 17, 18, 27 und 28 wie in den Figuren Fig. 3 und Fig. 4 ist jedoch vorteilhaft, da hierbei zusätzlich eine zusätzliche Abschirmung von Teilbereichen des Abschirmgehäuses erreicht wird. Dies ist insbesondere in den in den Figuren 1 und 2 gezeigten Ausführungsbeispielen von Vorteil, wo keine durchgängige Abschirmung im Bereich der Steckerdurchführungen 113 und 123 vorhanden ist.

Fig. 4 zeigt das Gehäuseteil 2 mit den Rippen 261 und den Stegen 27 und 28, die jeweils Zähne 271 bzw. 281 aufweisen.

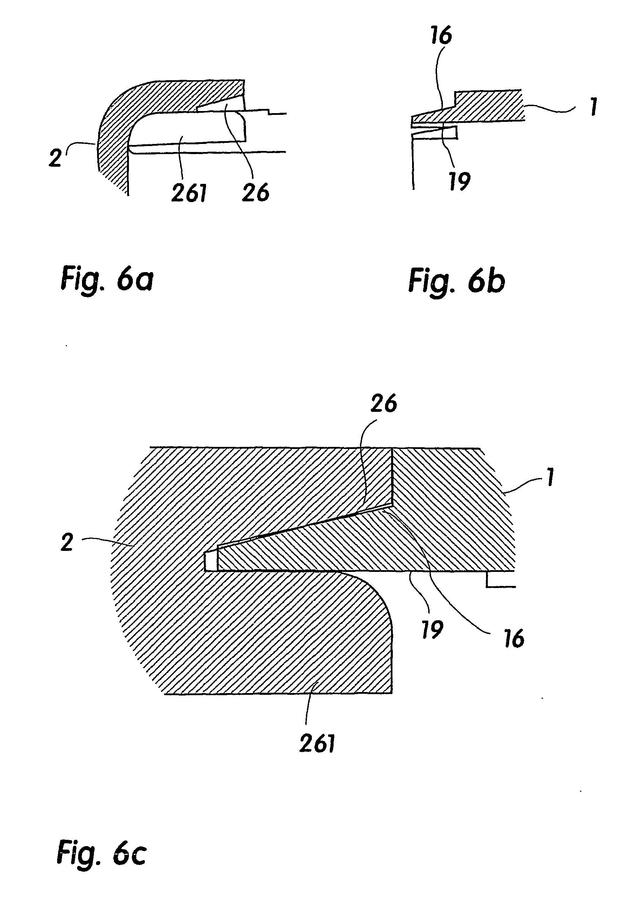

Der Aufbau der Segmente 30 bis 47 ist beispielhaft in der Fig. 6b gezeigt, die einen Ausschnitt aus einem Querschnitt 51 durch das Gehäuseteil 1 zeigt. Wie in Fig. 6b erkennbar, sind die Segmente 16 leicht abgeschrägt und weisen auf der Gehäuseaußenseite eine Fläche 16 und auf der Gehäuseinnenseite eine Fläche 19 auf.

Weiter ist in Fig. 6a ein Ausschnitt aus einem Querschnitt 52 durch den Gehäuseteil 2 gezeigt. Wie in Fig. 6a zu erkennbar, ist die Innenseite des Randbereiches des Gehäuseteils 2 abgeschrägt und weist eine Fläche 26 auf. Weiter ist in Fig. 6a eine Rippe 261 gezeigt.

Die Flächen 16 und die Flächen 26 wirken als Übermaßpassung zusammen und werden beim Zusammenfügen der Gehäuseteile 1 und 2 gegeneinander gepreßt. Wie in den Figuren 6a, 6b und 6c gezeigt, weisen die Flächen 16 und 26 um einige Grad unterschiedliche Neigungswinkel auf, wobei in der Endstellung des Fügevorgangs das Übermaß diese Übermaßpassung zum Tragen kommt und der Randbereich des Gehäuseteils 1 in Richtung der Gehäuseinnenseite gedrückt wird und sich dementsprechend leicht in diese Richtung verbiegt. Das in der Endstellung des Fügevorgangs bestehende Übermaß zwischen den Flächen 26 und 16 beträgt vorzugsweise 0,1 mm bis 0, 2 mm. Die Neigungswinkeldifferenz zwischen den Flächen 26 und 16 beträgt vorzugsweise in etwa 2°.

Im Bereich der Rippen 261 ergibt sich der in Fig. 6c gezeigte Effekt.

Fig. 6c zeigt einen Ausschnitt aus einem Querschnitt 53 durch das zusammengefügte, aus den Gehäuseteilen 1 und 2 bestehende Abschirmgehäuse.

Wie in Fig. 6 erkennbar, werden die Flächen 16 und 26 der der Gehäuseteile 1 bzw. 2 in der Endstellung des Fügevorgangs durch das Übermaß aufeinander gepreßt. Weiter wird die Fläche 19 des Gehäuseteil 1 von der Rippe 261 des Gehäuseteils 2 in Richtung der Außenseite des Abschirmgehäuses gepreßt.

Damit wirkt im Bereich der Rippe 261 auf den Randbereich des Gehäuseteils 1 zum einen eine durch das Übermaß bewirkte Kraft, die den Randbereich in Richtung des Gehäuseinneren drückt und zum anderen eine einer dadurch bewirkten Ausgleichsbewegung des Endbereiches des Gehäuseteils 1 entgegengerichtete Kraft, die durch die Rippe 261 bewirkte wird. Hierdurch wird eine Keilkraft auf den Randbereich des Gehäuseteils 1 ausgeübt, durch die sich die Randbereiche der ineinander greifenden Gehäuseteile 1 und 2 im Bereich der Rippe 261 partiell verkeilen.

Es ist natürlich möglich, daß die Rippe 261 anders als in den Figuren 6c und 2 dargestellt ausgeformt sind. Vorzugsweise haben die Rippen 261 eine konische Form. Die Rippen 261 können jedoch auch rechteckförmig ausgestaltet sein, wobei die der Außenseite zugewandete obere Ecke abgeschrägt ist, um das Zusammenfügen der Gehäuseteile 1 und 2 zu erleichtern.

Auch kann die Anzahl der Rippen 261 sowie die Breite der Rippen 261 variiert werden.

Vorzugsweise ist hierbei pro Segment mindestens eine Rippe vorzusehen. So sind in Fig. 4 mehrere Rippen 261 gezeigt, die jeweils einem der Segmente 31 bis 37 und 40 bis 46 zugeordnet sind. Den Segmenten 31, 37, 40 und 46 ist jeweils nur eine Rippe 261 zugeordnet. Den Segmenten 47, 39, 38 und 30 sind keine Rippen zugeordnet. Den Segmenten 32 bis 36 und 41 bis 45 sind jeweils zwei Rippen zugeordnet. Diese Rippen sind hierbei jeweils derart angeordnet, daß die Rippen benachbart zu den das jeweilige Segment begrenzenden Nuten in das jeweilige zugeordnete Segment eingreifen. Es ist natürlich auch möglich, daß mehr als zwei Rippen pro Segment verwendet werden.

Weiter ist es auch möglich, daß die Flächen 16 und 26 anders als in Fig. 6a und Fig. 6b gezeigt zueinander angeordnet sind. Es ist beispielsweise auch möglich, daß die Flächen 26 und 16 nicht über einen unterschiedlichen Neigungswinkel verfügen, sondern keinen oder den gleichen Neigungswinkel besitzen und der oberste Rand der Flächen 16 abgerundet ist, um ein Zusammenfügen der Gehäuseteile 1 und 2 zu ermöglichen. Weiter ist es auch möglich, daß der Neigungswinkel der Flächen 16 und 26 sich mit Entfernung vom Rand des jeweiligen Gehäuseteils verändert.

Weiter ist es auch möglich, daß die Flächen 16 und 26 seitenverkehrt zu den Darstellungen nach Fig. 6a und Fig. 6b angeordnet sind und die Fläche 16 an der Innenseite des Gehäuseteils 1 angeordnet ist und die Fläche 26 an der Außenseite des Gehäuseteils 2 angeordnet ist.

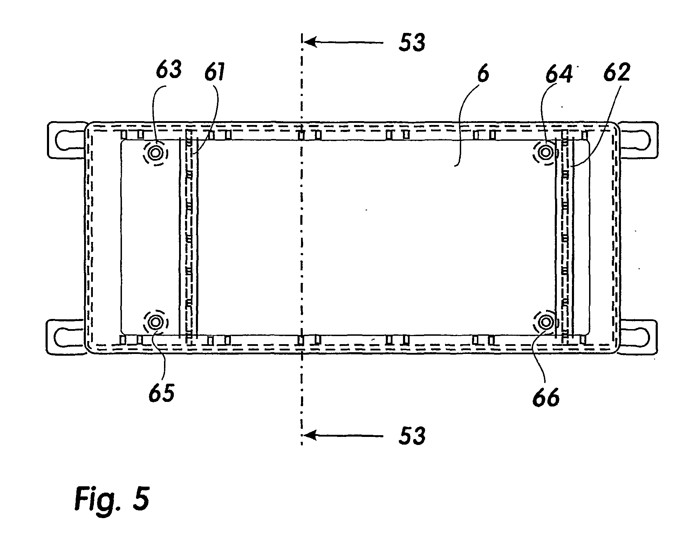

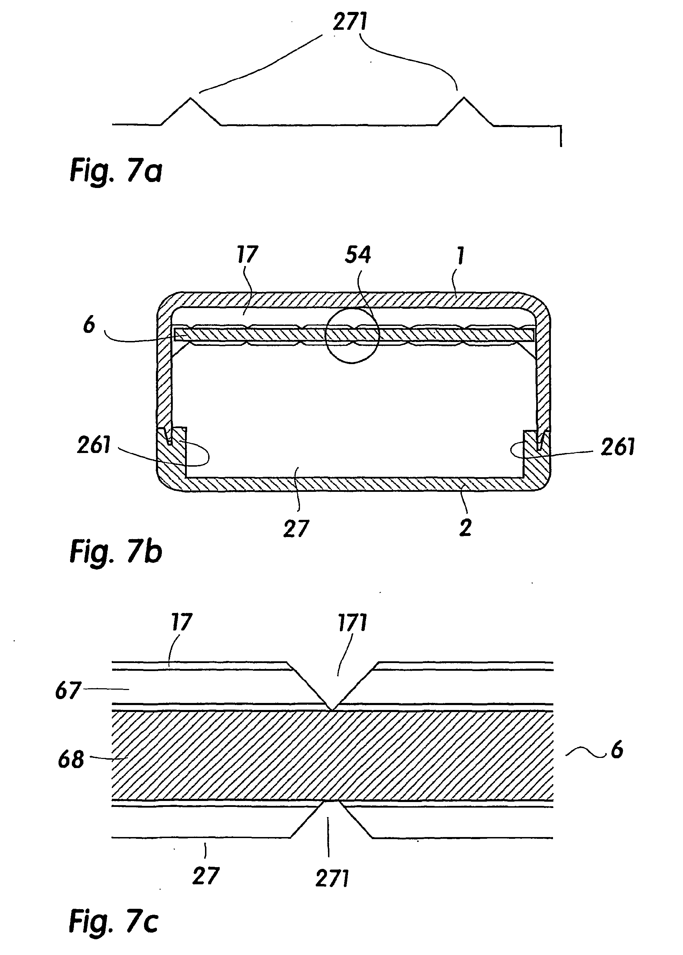

Die elektrische Kontaktierung zwischen dem Abschirmgehäuse und der innerhalb des Abschirmgehäuses angeordneten elektronischen Schaltung wird im folgenden anhand der Figuren 5, 7a, 7b und 7c erläutert:

Fig. 5 zeigt einen Längsschnitt durch ein Abschirmgehäuse, daß sich aus den zusammengefügten Gehäuseteilen 1 und 2 zusammensetzt. Innerhalb dieses Gehäuses ist eine Platine 6 angeordnet. Die Platine 6 weist vier Bohrungen 63, 64, 65 und 66 auf, die passergenau zu den Schraubungen der Abstandszapfen 151, 152, 251, 252, 254 und 253 angeordnet sind. Durch die Bohrungen 63 bis 66 ist die Verschraubung des Abschirmgehäuses geführt, so daß die Platine 6 durch die Verschraubung in Längs- und Querrichtung und durch die Abmessungen der Abstandszapfen 151, 152 und 251 bis 254 in der Höhe mechanisch fixiert wird.

Weiter weist die Platine 6 mehrere Kontaktflächen auf, mittels der eine galvanische Verbindung zwischen dem Abschirmgehäuse und dem Massekontakt der elektrischen Schaltung hergestellt wird. Fig. 5 zeigt zwei Kontaktflächen 61 und 62, die in einem Bereich der Platine 6 angeordnet sind, der in Berührung zu den Stegen 27 bzw. 28 steht. In gleicher Weise sind an der Unterseite der Platine 6 weitere Kontaktflächen angebracht, die ihrerseits in Berührung mit den Stegen 17 bzw. 18 stehen. Die Kontaktflächen 61 und 62 bestehen beispielsweise auf einer dünnen, auf der Platinoberfläche aufgebrachten Zinnschicht, die beispielsweise eine Dicke von 35 µm besitzt.

Die der Platine 6 zugewandten Stirnflächen der Stege 17,18, 27 und 28 weisen eine Form auf, wie sie beispielsweise in Fig. 7a gezeigt ist. Fig. 7a zeigt hier zwei in einem Abstand von etwa 8 mm angeordnete Zähne, die dreieckförmig sind und eine etwa einen 90°-Winkel bildende Spitze aufweisen. Es ist natürlich auch möglich, daß die Stege 17, 18, 27 und 28 eine andere Anzahl von Zähnen aufweisen. Hier ist jedoch darauf zu achten, daß der Abstand der Zähne kleiner als die Länge der abzuschirmenden Wellenlänge ist, wenn die Abschirmwirkung der Stege ausgenützt werden soll. Die Form der Zähne 271 kann ebenfalls variiert werden. Hier ist jedoch darauf zu achten, daß die Zähne 271 noch geometrisch verformbar sind und die Spitze somit keine zu starke Rundung besitzt.

Fig. 7b zeigt, wie die Stege 17 und 27 zusammenwirken, um eine galvanische Verbindung zwischen den Kontaktflächen der Platine 6 und den Gehäuseteilen 1 und 2 herzustellen. Wie aus Fig. 7b und aus den Figuren 3 und 4 ersichtlich, sind die Stege 17 und 27 symmetrisch zueinander angeordnet, so daß keine Torsionskräfte auf die Platine wirken. Die der Platine 6 zugewandten Stirnflächen der Stege 17 und 18 besitzen eine zumindest partiell leitfähige Oberfläche. Weiter weisen die Stege 17 und 27 gegenüber der im Abschirmgehäuse angeordneten Platine 6 ein Übermaß auf. Wie bereits oben erläutert, kann dieses Übermaß durch die Bemessung der Abstandszapfen 151, 251, 252, 254 und 253 eingestellt werden. Weiter ist es möglich, dieses Übermaß durch die entsprechende Gestaltung der Höhe der symmetrisch angeordneten Stege 17 und 27 bzw. 18 und 28 eingestellt werden.

Das Übermaß ist hierbei so bemessen, daß beim Zusammenfügen der Gehäuseteile 1 und 2 die Stirnflächen der Stege 17, 18, 27 und 28 derart gegen die zugeordneten Kontaktflächen der Platine gepreßt werden, daß eine Verformung der Zähne 271 und 281 und eine galvanische Verbindung zwischen den Gehäuseteilen und den Kontaktflächen der Platine 6 bewirkt wird. Dies ist beispielsweise in Fig. 7c dargestellt:

Fig. 7c zeigt die Platine 6, die von einem Platinenträger 68 und zwei jeweils eine Kontaktfläche bildenden metallischen Schicht 67 gebildet wird. Die Schichten 67 werden beispielsweise jeweils von einer dünnen Zinnschicht gebildet. Wie in Fig. 7c erkennbar, wird der Zahn 171 des Steges 17 beim Zusammenfügen der Gehäuseteile 1 und 2 in die weiche, metallische Schicht 67 eingepreßt. Hierbei dringt der Zahn 171 jedoch nicht so tief in die metallische Schicht 67 ein, daß die Spitze des Zahns 171 auf den Platinenträger 68 trifft. Wie in Fig. 7c erkennbar, wird in diesem Fall die Spitze des Zahns 171 nicht verformt.

Auf der anderen Seite der Platine 6 ist das Übermaß des Steges 27 gegenüber der Platine 6 größer gewählt. Der Zahn 271 des Steges 27 wird hier beim Zusammenfügen der Gehäuseteile 1 und 2 in die weiche, metallische Schicht 67 eingepreßt und verformt sich, wie in Fig. 7c angedeutet, beim Auftreffen auf den Platinenträger 68.

Weiter ist es auch möglich, daß das Übermaß zwischen dem Steg 17 und der Platine 6 sowie zwischen dem Steg 27 und der Platine 6 annähernd gleich ist: Es besteht so die Möglichkeit, daß sowohl die Zähne des Steges 17 als auch die Zähne des Steges 27 nicht so tief in die metallische Schicht 67 eindringen, daß die Spitzen dieser Zähne auf den Platinenträger 68 treffen. Weiter ist es möglich, daß sowohl die Zähne des Steges 17 als auch die Zähne des Steges 27 beim Zusammenfügen der Gehäuseteile 1 und 2 auf den Platinenträger 68 auftreffen und sich verformen.

Es ist natürlich auch möglich, daß die Kontaktflächen 61 und 62 anders als in Fig. 5 dargestellt geformt sind und beispielsweise nur in Teilbereichen der zugeordneten Stege vorhanden sind.

## Patentansprüche

1. Abschirmgehäuse zur Aufnahme einer elektronischen Schaltung (6) bestehend aus mindestens zwei elektrisch leitfähigen Gehäuseteilen (1, 2), die zumindest bereichsweise formschlüssig ineinander greifen,
**dadurch gekennzeichnet,**
**daß** formschlüssig ineinander greifende erste und zweite Randbereiche eines ersten Gehäuseteils (1) bzw. eines zweiten Gehäuseteils (2) einander zugewandte erste Flächen (16) bzw. zweite Flächen (26) aufweisen, wobei die ersten Flächen an der Außenseite des ersten Gehäuseteils und die zweiten Flächen an der Innenseite des zweiten Gehäuseteils angeordnet sind und die ersten und zweiten Flächen als Übermaßpassung zusammenwirken und beim Zusammenfügen des ersten Gehäuseteils (1) und des zweiten Gehäuseteils (2) gegeneinander gepreßt werden, daß mindestens ein Bereich des ersten Randbereichs mit einer der ersten Flächen (16) und/oder ein Bereich des zweiten Randbereichs mit einer der zweiten Flächen (26) durch Nuten segmentiert ist, daß der zweite Randbereich mindestens eine Rippe (261) aufweist, die auf eine an der Innenseite des ersten Gehäuseteils angeordnete dritte Fläche (19) des ersten Randbereiches zum Erzeugen einer Keilkraft eingreift, und daß die ersten und zweiten Flächen (16, 26) und/oder die mindestens eine Rippe (261) und die dritte Fläche (19) eine zumindest bereichsweise elektrisch leitfähige Oberfläche aufweisen, so daß eine galvanische Verbindung der ineinander greifenden ersten und zweiten Gehäuseteile (1, 2) durch das Zusammenfügen des ersten und des zweiten Gehäuseteils (1, 2) bewirkt wird.

2. Abschirmgehäuse nach Anspruch 1,
**dadurch gekennzeichnet,**
**daß** das erste Gehäuseteil (1) und das zweite Gehäuseteil (2) aus einem leitfähigen Kunststoff bestehen.

3. Abschirmgehäuse nach Anspruch 1,
**dadurch gekennzeichnet,**
**daß** das erste Gehäuseteil (1) und das zweite Gehäuseteil (2) von Kunststoffformteilen gebildet werden, die mit einer leitfähigen Schicht versehen sind.

4. Abschirmgehäuse nach Anspruch 1,
**dadurch gekennzeichnet,**
**daß** die ersten Flächen (16) gegenüber den zweiten Flächen (26) ein Übermaß von 0,1 mm bis 0,2 mm aufweisen.

5. Abschirmgehäuse nach Anspruch 1,
**dadurch gekennzeichnet,**
**daß** ein Übermaß durch eine Neigungswinkeldifferenz zwischen ersten Flächen (16) und zweiten Flächen (26) bewirkt wird.

6. Abschirmgehäuse nach einem der obigen Ansprüche,
**dadurch gekennzeichnet,**
**daß** der erste Randbereich segmentiert ist und der zweite Randbereich nicht segmentiert ist.

7. Abschirmgehäuse nach einem der obigen Ansprüche,
**dadurch gekennzeichnet,**
**daß** durch Nuten begrenzte Bereiche des ersten Randbereiches Segmente (30 bis 47) des ersten Randbereiches definieren und daß der zweite Randbereich mindestens eine Rippe (261) pro Segment des ersten Randbereiches aufweist, wobei die Rippen (261) zum Eingriff auf die jeweiligen zugeordneten Segmente (30 bis 47) des ersten Randbereiches angeordnet sind.

8. Abschirmgehäuse nach Anspruch 7,
**dadurch gekennzeichnet,**
**daß** der zweite Randbereich zwei Rippen (261) aufweist, die zum Eingriff in ein Segment (32 bis 36, 41 bis 45) des ersten Randbereiches angeordnet sind, so daß die Rippen (261) jeweils benachbart zu den das Segment begrenzenden Nuten in das Segment (32 bis 36, 41 bis 45) des ersten Randbereiches eingreifen.

9. Abschirmgehäuse nach einem der obigen Ansprüche,
**dadurch gekennzeichnet,**
**daß** die Nuten zur Segmentierung der ersten Flächen (16) in einem Abstand kleiner als 25 mm angeordnet sind.

10. Abschirmgehäuse nach einem der obigen Ansprüche,
**dadurch gekennzeichnet,**
**daß** die mindestens eine Rippe (261) konisch ausgeformt ist.

11. Abschirmgehäuse nach einem der obigen Ansprüche,
**dadurch gekennzeichnet,**
**daß** die Rippen (261) nur in Bereichen des Gehäuses vorgesehen sind, in denen eine EMV-Abschirmung vorgesehen ist.

## Claims

1. Screen housing for receiving an electronic circuit (6) comprising at least two electrically conducting housing parts (1, 2), which engage positively in each other, at least in regions,
**characterised in that**
the mutually engaging first and second edge regions of a first housing part (1) and a second housing part (2) have first surfaces (16) and second surfaces (26) respectively, which face one another, which surfaces interact as an overdimensioned fit and are pressed against each other when the first housing part (1) and the second housing part (2) are joined together, **in that** at least one of the first surfaces (16) and/or second surfaces (26) is segmented by grooves, **in that** the second edge region has at least one rib (261) which engages on a third surface (19) of the first edge region to generate a wedge force, and **in that** the first and second surfaces (16, 26) and/or the at least one rib (261) and the third surface (19) have a surface that is electrically conducting, at least in regions, so that a galvanic connection of the mutually engaging first and second housing parts (1, 2) is effected by the joining together of the first and second housing parts (1, 2).

2. A screen housing according to Claim 1,
**characterised in that**
the first housing part (1) and the second housing part (2) consist of a conductive plastic.

3. The screen housing according to Claim 1,
**characterised in that**
the first housing part (1) and the second housing part (2) are formed of plastic mouldings which are connected to a conductive layer.

4. The screen housing according to Claim 1,
**characterised in that**
the first surfaces (16) have an over-dimension of 0.1 mm to 0.2 mm relative to the second surfaces (26).

5. The screen housing according to Claim 1,
**characterised in that**
an over-dimension is effected by a difference in angle of inclination between first surfaces (16) and second surfaces (26).

6. The screen housing according to the above claims,
**characterised in that**
the first edge region is segmented and the second edge region is not segmented.

7. The screen housing according to one of the above claims,
**characterised in that**
regions of the first edge region limited by grooves define segments (30 to 47) of the first edge region, and **in that** the second edge region has at least one rib (261) per segment of the first edge region, wherein the ribs (261) are arranged to engage on the corresponding assigned segments (30 to 47) of the first edge region.

8. The screen housing according to Claim 7,
**characterised in that**
the second edge region has two ribs (261) which are arranged to engage in one segment (32 to 36, 41 to 45) of the first edge region so that the ribs (261) each engage in the segment (32 to 36, 41 to 45) of the first edge region adjacent to the grooves limiting the segment.

9. The screen housing according to one of the above claims,
**characterised in that**
the grooves are arranged to segment the first surfaces (16) at a distance of less than 25 mm.

10. The screen housing according to one of the above claims,
**characterised in that**
the at least one rib (261) is conical in shape.

11. The screen housing according to one of the above claims,
**characterised in that**
the ribs (261) are only provided in regions of the housing in which an EMV screen is provided.

## Revendications

1. Boîtier de blindage pour l'admission d'un circuit électronique (6) constitué d'au moins deux parties de boîtier conductrices (1, 2), qui s'engagent au moins en partie l'une dans l'autre par complémentarité de forme,
**caractérisé en ce que**
la première et la deuxième régions de bord d'une première partie de boîtier (1) ou d'une deuxième partie de boîtier (2), qui s'engagent au moins en partie l'une dans l'autre par complémentarité de forme, comportent des premières surfaces (16) ou des deuxièmes surfaces (26) tournées les unes vers les autres, les premières surfaces étant disposées du côté extérieur de la première partie de boîtier et les deuxièmes surfaces étant disposées du côté intérieur de la deuxième partie de boîtier, et la première et la deuxième surfaces coopérant en tant qu'ajustement de surplus et étant pressées l'une contre l'autre lors de l'assemblage entre la première partie de boîtier (1) et la deuxième partie de boîtier (2), **en ce qu'**au moins une zone de la première région de bord est segmentée par des rainures avec l'une des premières surfaces (16) et/ou une zone de la deuxième région de bord est segmentée par des rainures avec l'une des deuxièmes surfaces (26), **en ce que** la deuxième région de bord comporte au moins une nervure (261) s'engageant sur une troisième surface (19) de la première région de bord, laquelle est disposée du côté intérieur de la première partie de boîtier, pour produire une force de coin, et **en ce que** la première et la deuxième surfaces (16, 26) et/ou la au moins une nervure (261) ainsi que la troisième surface (19) comportent une surface au moins partiellement électriquement conductrice, de façon à produire une liaison galvanique entre la première et la deuxième parties de boîtier (1, 2) s'engageant l'une dans l'autre, par l'assemblage de la première et de la deuxième parties de boîtier (1, 2).

2. Boîtier de blindage selon la revendication 1,
**caractérisé en ce que**
la première partie de boîtier (1) et la deuxième partie de boîtier (2) sont constituées d'une matière plastique conductrice.

3. Boîtier de blindage selon la revendication 1,
**caractérisé en ce que**
la première partie de boîtier (1) et la deuxième partie de boîtier (2) sont formées par des pièces moulées en plastique, qui sont pourvues d'une couche conductrice.

4. Boîtier de blindage selon la revendication 1,
**caractérisé en ce que**
les premières surfaces (16) comportent un surplus de 0,1 mm à 0,2 mm par rapport aux deuxièmes surfaces (26).

5. Boîtier de blindage selon la revendication 1,
**caractérisé en ce que**
un surplus est produit par une différence d'angle d'inclinaison entre les premières surfaces (16) et les deuxièmes surfaces (26).

6. Boîtier de blindage selon l'une des revendications précédentes,
**caractérisé en ce que**
la première région de bord est segmentée et la deuxième région de bord n'est pas segmentée.

7. Boîtier de blindage selon l'une des revendications précédentes,
**caractérisé en ce que**
des zones de la première région de bord, qui sont délimitées par des rainures, définissent des segments (30 à 47) de la première région de bord et **en ce que** la deuxième région de bord comporte au moins une nervure (261) par segment de la première région de bord, les nervures (261) étant, pour l'engagement, disposées sur chacun des segments (30 à 47) correspondants de la première région de bord.

8. Boîtier de blindage selon la revendication 7,
**caractérisé en ce que**
la deuxième région de bord comporte deux nervures (261), qui pour l'engagement sont disposées sur un segment (32 à 36, 41 à 45) de la première région de bord, de façon à ce que les nervures (261) s'engagent respectivement dans le segment (32 à 36, 41 à 45) de la première région de bord, en étant respectivement adjacentes aux nervures délimitant le segment.

9. Boîtier de blindage selon l'une des revendications précédentes,
**caractérisé en ce que**
les rainures destinées à la segmentation des premières surfaces (16) sont disposées en respectant un écart inférieur à 25 mm.

10. Boîtier de blindage selon l'une des revendications précédentes,
**caractérisé en ce que**
la au moins une nervure (261) est formée de manière conique.

11. Boîtier de blindage selon l'une des revendications précédentes,
**caractérisé en ce que**
les nervures (261) ne sont prévues que dans certaines régions du boîtier, dans lesquelles est prévu un blindage CEM.
